# EUROPÄISCHE PATENTSCHRIFT

(11) **EP 3 567 389 B1**
(45) Veröffentlichungstag und Bekanntmachung des Hinweises auf die Patenterteilung: **01.06.2022**
(21) Anmeldenummer: 19171904.6
(22) Anmeldetag: 30.04.2019
(51) Int. Cl.: G01R 31/52, G01R 31/58, G01R 31/62, G01R 27/14

(54) **VERFAHREN ZUR KONTINUIERLICHEN ISOLATIONSÜBERWACHUNG EINER ELEKTRISCHEN LEITERANORDNUNG**
METHOD FOR THE CONTINUOUS INSULATION MONITORING OF AN ELECTRICAL CONDUCTOR
PROCÉDÉ DE SURVEILLANCE CONTINUE DE L'ISOLATION D'UN AGENCEMENT CONDUCTEUR ÉLECTRIQUE

(30) Priorität: 08.05.2018 DE 102018111061
(43) Veröffentlichungstag der Anmeldung: 13.11.2019
(73) Patentinhaber: Bender GmbH & Co. KG, 35305 Grünberg (DE)
(72) Erfinder: HACKL, Dieter, 35463 Fernwald (DE)
(74) Vertreter: advotec.

(56) Entgegenhaltungen:
- CN-U- 203 825 089
- DE-B3-102005 052 956
- DE-T2- 69 022 282
- DE-T2- 69 114 452
- FR-A1- 2 781 574
- US-A- 4 301 399
- US-A1- 2002 038 199
- US-B1- 6 265 880

## Beschreibung

Die Erfindung betrifft ein Verfahren zur kontinuierlichen Isolationsüberwachung einer elektrischen Leiteranordnung mit einem aktiven Leiter und einer von dem aktiven Leiter elektrisch isolierten Leiterstruktur.

Der verstärkte Einsatz elektrotechnischer und elektronischer Komponenten in innovativen Technologien, wie beispielsweise der Elektromobilität oder der Fotovoltaik, wirft auch neue Fragestellungen hinsichtlich der elektrischen Isolationseigenschaften der verwendeten Betriebsmittel auf.

So werden beispielsweise die normativen Anforderungen der Isolationskoordination für elektrische Betriebsmittel in Niederspannungsanlagen in der Normenreihe IEC 60664 beschrieben. Dabei werden Vorgaben über einzuhaltende Luft- und Kriechstrecken gemacht und Anforderungen an feste Isolierungen definiert. Diese Norm hat den Status einer Sicherheitsgrundnorm und wird daher von verschiedensten Errichtungs- und Produktnormen als Basis für die Definition von Anforderungen im Bereich der Isolationskoordination berücksichtigt.

Allerdings beruhten die zum Zeitpunkt der Entstehung der Norm getätigten Untersuchungen vornehmlich auf der Anwendung von ein- oder mehrphasigen Wechselstromversorgungssystemen. Der Einsatz von Frequenzumrichtertechnologien war zum Zeitpunkt der Forschungsaktivitäten noch nicht so verbreitet wie zum heutigen Zeitpunkt bei Einführung der oben genannten neuen Technologien.

Insbesondere wurden auch die heute bei Umrichteranwendungen typischen Mischspannungen aus Wechselspannungen, Gleichspannungen und schaltfrequenten Spannungsanteilen nicht berücksichtigt.

Im Rahmen aktueller Forschungsprojekte werden daher Untersuchungen zur normgerechten Dimensionierung von Luft- und Kriechstrecken auf Leiterplatten durchgeführt, wobei unterschiedliche Kombinationen aus Gleichspannungsamplituden, Leiterplattenmaterial und Schutzbeschichtung betrachtet werden. Als Ergebnis sind unter dem Einfluss von Feucht-Wärme-Zyklen Migrationseffekte festzustellen, die im Laufe der Zeit zu Lichtbögen und Bränden führen können.

Die Forschungsergebnisse lassen erkennen, dass eine Ausbildung von Migrationseffekten bereits im Vorfeld durch ein Absinken des Isolationswiderstands von 1 bis 10 GOhm im Gutzustand auf Werte unter 100 MOhm im Schlechtzustand detektiert werden kann.

Auch weitere Analysen und Bewertungen von Betriebsmitteln der Hochspannungstechnik gelangen zu dem Ergebnis, dass für den Gutzustand von Isoliersystemen ein Grenzwert oberhalb von 100 MOhm anzusetzen ist.

Als Nachteil bei der praktischen Umsetzung der Diagnosemessungen, insbesondere zur Messung des Isolationswiderstands, erweist sich, dass diese Messungen bis auf wenige Ausnahmen nur im Rahmen von Wartungsmaßnahmen, also offline an dem abgeschalteten Anlageteil durchgeführt werden können. Problematisch sind hierbei erstens die Nichtverfügbarkeit des Versorgungssystems während der Diagnosemessungen, zweitens der hohe Aufwand für den Systemumbau, um Diagnosemessungen zu ermöglichen, und drittens die unbeobachteten Zeiten zwischen den Wartungsintervallen.

Der Einsatz der bekannten Mess- und Prüfgeräte, die offline im Verlauf von Wartungsarbeiten für die oben beschriebenen Diagnosemessungen verwendet werden, als Online-Überwachungsgeräte ist erfahrungsgemäß nicht möglich, da die im Online-Betrieb vorhandenen Fremd- und Störspannungen die Messungen zu stark beeinträchtigen würden.

Aus der Patentschrift DE 691 14 452 T2 ist eine Isolations-Überwachungseinrichtung bekannt, bei der zwischen Netz und Erde ein Prüfsignal eingespeist und ein dem Isolationswiderstand proportionaler Fehlerstrom gemessen wird. Um Störfelder abzuschirmen ist die elektronische Schaltung von einem Faradaykäfig umgeben.

Die Offenlegungsschrift FR 2 781 574 A1 zeigt ein System und ein Verfahren zur sicheren Stromversorgung, wobei der Isolationszustand eines Kabels erkannt wird, welches Leiter und eine die Leiter außen umgebende leitende Ummantelung aufweist. An die leitende Ummantelung kann eine Überwachungsvorrichtung mit einer Gleichspannungsquelle gegen Erde angeschlossen werden, sodass eine äußere Beschädigung des Kabels durch ein von außen eindringendes, geerdetes Metallteil zu einem Stromfluss führt, der in der Überwachungsvorrichtung detektiert wird und somit die beschädigte Isolation anzeigt.

In der Patentschrift US 6,265,880 B1 sind eine Vorrichtung und ein Verfahren zum Feststellen des Durchscheuerns einer elektrischen Leitung offenbart. Die Leitung ist spiralförmig von einem Sensorelement umgeben, welches zur Auswertung eines in dem Sensorelement fließenden Stromes an verschiedene elektronische Schaltkreise angeschlossen werden kann. Anhand eines veränderten Stromflusses können ein Durchscheuern der Leitung oder ein Erdschluss erkannt werden.

Die weitere Patentschrift DE 690 22 282 T2 beschreibt eine Vorrichtung, mit der eine äußere Einwirkung in Form einer übermäßigen Quetschung einer Kabelanordnung festgestellt werden kann. Das Kabel ist von einer äußeren Isolierschicht umgeben, unter der eine halbleitende Schicht liegt, die mit einer Anzeigeschaltung verbunden ist. Wird die Kabelanordnung durch einen geerdeten Körper von außen übermäßig gequetscht und damit die Isolierschicht abgetragen, so führt das zu einem Stromfluss über die halbleitende Schicht und die Erdverbindung. Dieser Stromfluss wird in der Anzeigeschaltung ausgewertet und damit eine übermäßige Quetschung angezeigt.

Allerdings erscheint die Verwendung der vor allem im Niederspannungsbereich verbreiteten Isolationsüberwachungstechnik zur Beurteilung des Isolationszustandes von Anlagen, Betriebsmitteln oder Subsystemen (Leiterplatten) denkbar, da die Messtechnik in Isolationsüberwachungsgeräten robust ausgelegt ist, um unter dem Einfluss vorhandener Fremd- und Störspannungen ein korrektes Messergebnis zu liefern.

Jedoch ist der Einsatz dieser bekannten und normgemäß ausgeführten Isolationsüberwachungsgeräte zur Beurteilung des Isolationszustands nur in Systemen mit einer ungeerdeten Netzform (IT-System) möglich, und auch dort nur dann, wenn der Isolationswiderstandswert des Gesamtsystems deutlich oberhalb der scheinbar kritischen 100 MOhm-Grenze liegt.

Daneben werden Isolationsüberwachungsgeräte im Bereich der Öl- und Gasversorgung mit einem GOhm-Messbereich eingesetzt. Um das Isolationsniveau des Gesamtsystems nicht unter einen kritischen Wert sinken zu lassen, müssen hier allerdings nachteiligerweise Teile des Stromversorgungssystems über Trenneinrichtungen abgeschaltet werden. Bei diesem Vorgehen werden auch Isolationswiderstandsmessungen bezüglich des Isolationszustands von z. B. Unterwasserversorgungskabeln (Umbilical) aussagekräftig. Zur Beurteilung der Aussagekraft ist jedoch der Vergleich mit den Messwerten wichtig, die zu einem anfänglichen oder vorhergehenden Zeitpunkt erfasst worden sind.

Aus diesen Betrachtungen ergibt sich zum einen das Problem, dass mit der gängigen Isolationsüberwachungstechnik eine genaue Bestimmung des Isolationswiderstands nur möglich ist, wenn das Isolationsniveau des gesamten Stromversorgungssystems hinreichend hoch, d. h. oberhalb von 100 MOhm ist. Um diesem Problem entgegenzuwirken, sind aus dem Stand der Technik mehrere Lösungsansätze bekannt. Im Vordergrund steht dabei die zeitweise Abtrennung von Subsystemen mit niedrigem Isolationsniveau, um den Isolationswiderstand des verbleibenden Systems hinreichend zuverlässig bestimmen zu können. Anschließend erfolgt ein Vergleich mit vorhergehenden Messungen in dem gleichen Betriebszustand.

Weitere bekannte Maßnahmen sind die Verkürzung der Wartungsintervalle und die Verkürzung der Intervalle zwischen den normativ geforderten Wiederholungsprüfungen. Auch ein frühzeitiger Austausch kritischer Betriebsmittel in Verbindung mit einer Lagerhaltung von Ersatzteilen und dem Vorhalten von Bereitschaftsdiensten kann indirekt dazu beitragen, die elektrische Sicherheit zu erhöhen.

Die bekannten Maßnahmen aber sind mit Nachteilen behaftet. So können normgemäße Isolationsüberwachungsgeräte nur in ungeerdeten Stromversorgungssystemen eingesetzt werden, eine Trennung von Subsystemen ist nicht immer möglich, z. B. nicht in medizinischen Anwendungsbereichen, und kürzere Wartungsintervalle in Verbindung mit einer umfangreichen Lagerhaltung führen zu höheren Kosten.

Der vorliegenden Erfindung liegt die Aufgabe zugrunde, ein Verfahren vorzuschlagen, welches eine kontinuierliche Isolationsüberwachung einer elektrischen Leiteranordnung (Stromversorgungssystem) ermöglicht, die eine von dem aktiven Leiter elektrisch isolierte Leiterstruktur umfasst. Insbesondere in den Fällen, in denen der Gesamtisolationswiderstand durch Zusammenschalten von Anlagenteilen absinkt, sowie sowohl für geerdete als auch für ungeerdete Stromversorgungssysteme soll das Verfahren anwendbar sein.

In Verbindung mit den Merkmalen im des jeweiligen Oberbegriffs in den unabhängigen Ansprüchen wird vorausgesetzt, dass die Beschaffenheit der Leiteranordnung sowie die Anordnung des aktiven Leiters und der Leiterstruktur so ausgeführt sind, dass Einflussfaktoren, die dazu geeignet sind, den Isolationswiderstand der Leiteranordnung zu beeinflussen, gleichermaßen sowohl auf den aktiven Leiter als auch auf die Leiterstruktur einwirken. Für einen über den aktiven Leiter fließenden Messstrom als auch für einen über die Leiterstruktur fließenden Messstrom werden also nahezu identische Ausbreitungsbedingungen angenommen.

2- Diese Aufgabe wird durch Verfahren gemäß Ansprüchen 1, 2 und 3 gelöst.

Die aktiven Leiter können gegen Erde isoliert ausgeführt sein, niederohmig geerdet oder hochohmig geerdet sein. Damit werden alle Netzformen abgedeckt. Die Leiterstruktur ist nicht nur gegen die aktiven Leiter elektrisch isoliert ausgeführt, sondern auch gegen Erde - der Messaufgabe entsprechend - sehr hochohmig elektrisch isoliert ausgeführt.

Die Grundidee der vorliegenden Erfindung basiert auf der Annahme, dass eine Abschwächung des Isolationszustands durch mögliche Einflussfaktoren fast immer symmetrisch auf die Isolierung einwirkt und dieser Wirkungsbereich nicht auf die aktiven Leiter der Leiteranordnung begrenzt ist, sondern sich auf benachbarte Leiterstrukturen ausdehnt. Beispielsweise nehmen Temperatur-Feuchte-Zyklen Einfluss auf alle Isolationsbereiche, die diesen Zyklen ausgesetzt sind.

Es ist somit nicht notwendig, den Betriebsstrom-führenden, aktiven Leiter mit einer Messspannung zu beaufschlagen, sondern die Messspannung an eine räumlich benachbarte Leiterstruktur der Leiteranordnung zu legen, die den gleichen Einflussfaktoren ausgesetzt ist.

Der über diese Leiterstruktur, die Isolierung und über Erde fließende Messstrom kann dabei vorteilhafterweise einen Messpfad ausbilden, der einen höheren (Isolations-) Widerstandswert besitzt, sodass ein normgemäßes Isolationsüberwachungsgerät einsetzbar ist.

Am Beispiel einer Leiterplatte als elektrische Leiteranordnung bedeutet dies, dass eine Degradation oder eine Verschlechterung des Schutz- oder Isolierlacks nicht nur durch eine Isolationswiderstandsmessung an einem aktiven Leiter gegen Erde feststellbar ist, sondern auch an einer beliebigen, von den aktiven Leitern isolierten Leiterstruktur, die ebenfalls in den Schutz- oder Isolierlack eingebettet ist. Die Verwendung eines normgerechten Isolationsüberwachungsgeräts zur Bestimmung des Isolationswiderstands ist dabei von Vorteil, da bei abnehmendem Isolationsniveau der Leiteranordnung mit einem zunehmenden Störspannungspegel an der überwachten Leiterstruktur zu rechnen ist, ein dem Stand der Technik gemäßes Isolationsüberwachungsgerät aber in der Lage ist, diese Störspannungen zu eliminieren.

Im Rahmen der Aufgabenstellung einer kontinuierlichen Isolationsüberwachung ist davon auszugehen, dass ein derartiges Isolationsüberwachungsgerät auch Spannungskomponenten toleriert, die zwischen den aktiven Leitern und Erde auftreten und die anwendungsabhängig stark schwanken können.

In weiterer vorteilhafter Ausgestaltung werden als Leiterstruktur ein oder mehrere nicht Betriebsstrom-führende Leiter der Leiteranordnung verwendet.

Im Falle eines Versorgungskabels als Leiteranordnung bedeutet dies, dass eine Degradation oder eine Verschlechterung der Isolierung eines aktiven Leiters in dem Versorgungskabel abgeschätzt werden kann durch die Messung des Isolationswiderstands an einem oder mehreren nicht Betriebsstrom-führenden, ungenutzten Leitern, welche isoliert von den aktiven Leitern in demselben Kabelstrang angeordnet sind und somit den gleichen Störfaktoren, beispielsweise Umwelteinflüssen wie Temperatur oder Feuchtigkeit, ausgesetzt sind.

Weiterhin kann mit Vorteil als Leiterstruktur eine Schirmschicht verwendet werden.

Die Schirmschicht kann elektrisch halbleitend oder elektrisch leitend sein. So ist es bei einer Unterwasserversorgungsleitung denkbar, den Isolationswiderstand zwischen der halbleitenden Schirmschicht gegen Erde zu messen, um beispielsweise einen Wassereintritt zu detektieren.

Weiterhin kann im Fall eines Transformators als Leiteranordnung eine kapazitiv geerdete Schirmwicklung des Transformators als Leiterstruktur verwendet werden.

Eine Abnahme des zwischen der kapazitiv geerdeten Schirmwicklung und Erde gemessenen Isolationswiderstandswertes, beispielsweise aufgrund von Feucht-Wärme-Zyklen, kann als Indikator für einen kritischen Zustand des Isoliersystems des Transformators gewertet werden.

In vorteilhafter Weise ist das erfindungsgemäße Verfahren zur kontinuierlichen Isolationsüberwachung einer elektrischen Leiteranordnung sowohl eines ungeerdeten als auch eines geerdeten Stromversorgungssystems anwendbar.

Das erfindungsgemäße Verfahren ermöglicht es somit, eine kontinuierliche Überwachung des Isolationszustands von Leiteranordnungen unabhängig von der Netzform (geerdetes oder ungeerdetes Stromversorgungssystem) durchzuführen. Eine kontinuierliche Überwachung während des Betriebs erhöht die elektrische Sicherheit der zu überwachenden Leiteranordnung und vermeidet Betriebsstillstandszeiten.

Die messtechnischen Möglichkeiten der aktuellen Isolationsüberwachungstechnik bis in den GOhm-Bereich hinein sind dabei erfindungsgemäß zur Überwachung der Leiteranordnung, insbesondere der Kabelisolierung bei elektrischen Anlagen oder bei der Überwachung der Isolierung von Betriebsmitteln, vorteilhaft auch dann nutzbar, wenn das Isolationsniveau beispielsweise eines ungeerdeten Stromversorgungssystems zu niedrig wäre, um eine Isolationsüberwachung gemäß dem Stand der Technik zu ermöglichen.

Darüber hinaus ist das erfindungsgemäße Verfahren für geerdete Stromversorgungssysteme geeignet.

Weitere vorteilhafte Ausgestaltungsmerkmale ergeben sich aus der nachfolgenden Beschreibung und den Zeichnungen, die eine bevorzugte Ausführungsform der Erfindung sowie Anwendungen der Erfindung anhand von Beispielen erläutern. Es zeigen
- **Fig. 1:**: schematisch ein verzweigtes, ungeerdetes Stromversorgungssystem zur Verdeutlichung der Problemstellung,
- **Fig. 2:**: den Verlauf eines Gesamtisolationswiderstands,
- **Fig. 3:**: eine Anwendung des erfindungsgemäßen Verfahrens in Verbindung mit einer Leiterplatte,
- **Fig. 4:**: eine Anwendung des erfindungsgemäßen Verfahrens in Verbindung mit einer Unterwasserversorgungsleitung und
- **Fig. 5:**: eine Anwendung des erfindungsgemäßen Verfahrens in Verbindung mit einem Transformator.

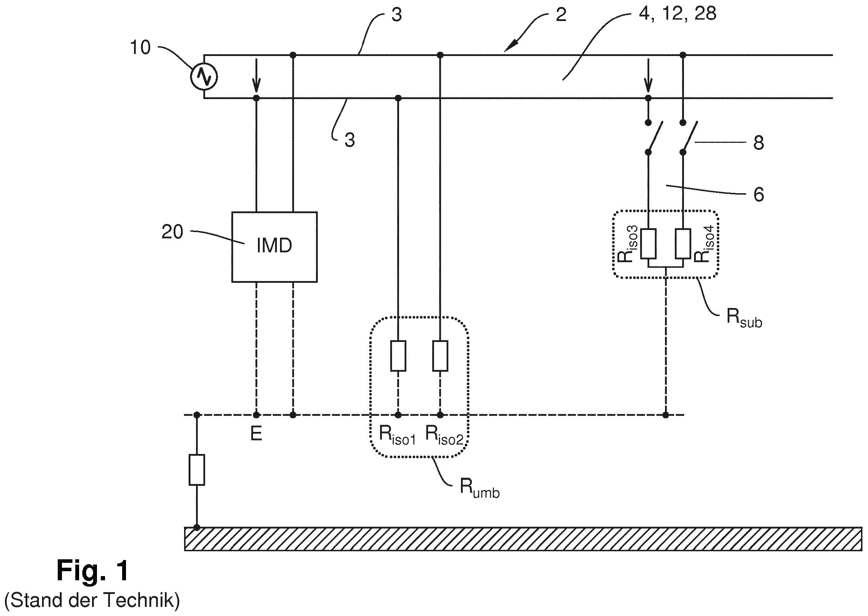

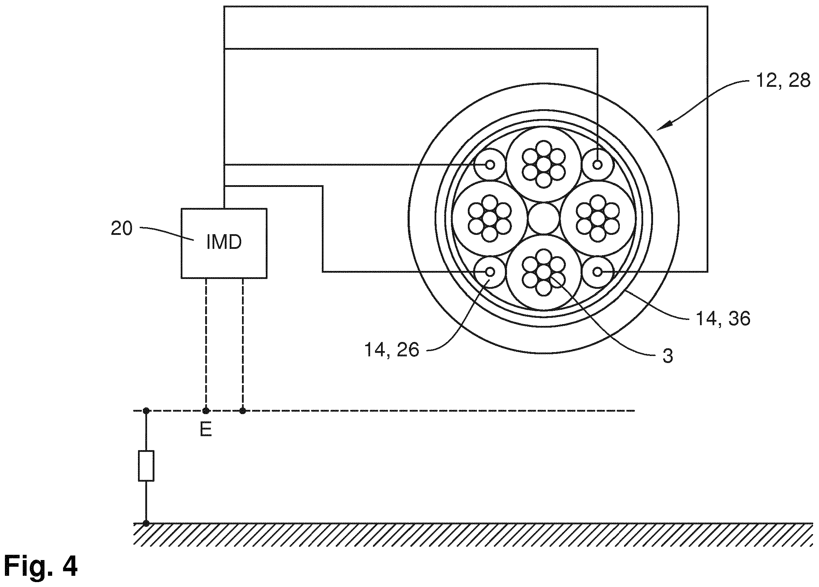

Zur Verdeutlichung der Problemstellung ist in **Fig. 1** ein Stromversorgungssystem 2 dargestellt, welches aus einem Hauptsystem 4 und einem Subsystem 6 besteht und von einer Stromquelle 10 gespeist wird. Das Hauptsystem 4 stellt eine Leiteranordnung 12 dar, die zwei aktive Leiter 3 umfasst. In dem vorliegenden Beispiel ist die Leiteranordnung 12 als Unterwasserversorgungsleitung 28 (siehe Fig. 4) ausgeführt.

Das Hauptsystem 4 sowie das Subsystem 6 sind jeweils durch die Isolationswiderstände Rᵢₛₒ₁ bis Rᵢₛₒ₄ charakterisiert. Zur Isolationswiderstandsmessung ist dem Stand der Technik entsprechend ein normgemäßes Isolationsüberwachungsgerät 20 zwischen die aktiven Leiter 3 und Erde E geschaltet. Das Isolationsüberwachungsgerät 20 überlagert dem Stromversorgungssystem 2 eine Messspannung, wobei sich der Messstromkreis über die aktiven Leiter 3 und die Isolationswiderstände Rᵢₛₒ₁ bis Rᵢₛₒ₄ gegen Erde schließt. Der Isolationswiderstand R_{umb} des Hauptsystems 4 ergibt sich aus der Parallelschaltung des Isolationswiderstands Rᵢₛₒ₁ und des Isolationswiderstands Rᵢₛₒ₂, der Isolationswiderstand R_{sub} des Subsystems 6 ergibt sich aus der Parallelschaltung des Isolationswiderstands Rᵢₛₒ₃ und des Isolationswiderstands Rᵢₛₒ₄. Der Gesamtisolationswiderstand des Stromversorgungssystems 2 wiederum ergibt sich aus der Parallelschaltung des Isolationswiderstands R_{umb} des Hauptsystems 4 und des Isolationswiderstands R_{sub} des Subsystems 6. Infolge der Parallelschaltung der Isolationswiderstände Rᵢₛₒ₁ bis Rᵢₛₒ₄ sinkt das Isolationsniveau des Stromversorgungssystems 2. Vor dem Hintergrund der besonderen Aufgabenstellung, den Isolationswiderstand einzelner Anlagenteile eines ungeerdeten Stromversorgungssystems zu bestimmen, deren Isolationsniveau deutlich - um 10-er Potenzen - höher ist, müssen diese sehr viel hochohmiger gegen Erde isolierten Anlagenteile separiert werden. Dazu sind dem Stand der Technik gemäß Trennschalter 8 zur Abschaltung des Subsystems 6 vorgesehen. Diese Trennschalter dienen der Separierung des sehr viel hochohmiger gegen Erde isolierten Hauptsystems 4 gegenüber dem sehr viel niederohmiger gegen Erde isolierten Subsystem 6.

In der Praxis stehen diese Trennschalter 8 für eine Vielzahl von Trennschaltern, die eine Separierung von einer Vielzahl von Subsystemen 6 ermöglichen. In nachteiliger Weise ist der Aufwand eines Separierungsvorgangs erstaunlich hoch, da diese Trennung in Tiefen von einigen Tausend Metern im Meer durch Roboter erfolgen muss.

Ist beispielsweise die Leiteranordnung 12 als Unterwasserversorgungsleitung 28 (Fig. 4) ausgeführt, so wird daher versucht, das Gesamtisolationsniveau durch selektives Abschalten von Anlagenteilen in einen Bereich des Gesamtisolationswiderstands oberhalb von 100 MOhm zu erhöhen.

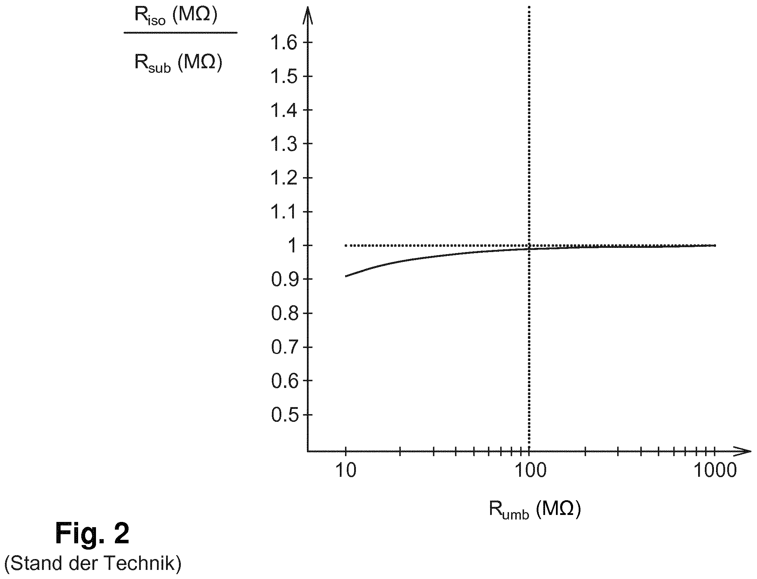

Die **Fig. 2** zeigt in einem Diagramm das Verhältnis von dem Gesamtisolationswiderstand Rᵢₛₒ des Stromversorgungsystems 2 zu dem Isolationswiderstand R_{sub} des Subsystems 6 in Abhängigkeit des Isolationswiderstands R_{umb} des Hauptsystems 4.

Deutlich zu erkennen ist die erwartete geringe Änderung des von dem Isolationsüberwachungsgerät 20 bestimmten Gesamtisolationswiderstandswert Rᵢₛₒ bei einer Parallelschaltung des Subsystems 6 mit einem Isolationsniveau von ca. einem MOhm und einem sich zwischen 10 MOhm und 1 GOhm verändernden Isolationswiderstand R_{umb} des als Unterwasserversorgungskabel 28 ausgeführten Hauptsystems 4.

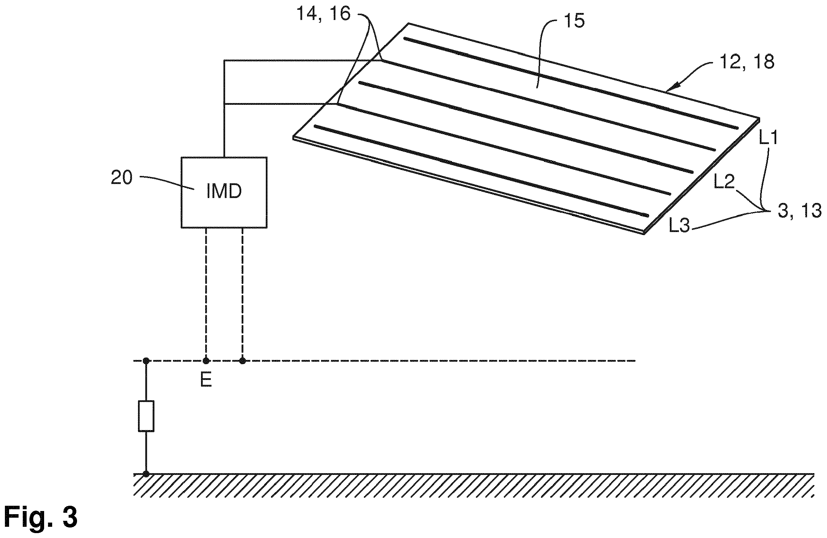

Auf Basis des gemessenen Gesamtisolationswiderstands Rᵢₛₒ kann in diesem Beispiel kaum eine Aussage über den Zustand der Isolierung des Hauptsystems 4 (Leiteranordnung 12 in Form der Unterwasserversorgungsleitung 28) gemacht werden. **Fig. 3** zeigt die Anwendung des erfindungsgemäßen Verfahrens auf eine als Leiterplatte 18 ausgeführte Leiteranordnung 12. Die Leiteranordnung 12 umfasst als aktive Leiter 3 Leiterbahnen 13 und als Leiterstruktur 14 weitere Leiterbahnen 16. Abweichend von dem bekannten Stand der Technik ist das Isolationsüberwachungsgerät 20 nicht an die aktiven Leiterbahnen 13 angekoppelt, sondern an die weiteren Leiterbahnen 16, die isoliert von den aktiven Leitern 3, 13 in einer gemeinsamen Isolierlackschicht 15 eingebettet sind. Auch hier gilt die Voraussetzung, dass die Isolierlackschicht 15 hinsichtlich der Bestimmung eines Isolationswiderstands den gleichen Einfluss sowohl auf die aktiven Leiter 3, 13 als auch auf die weiteren Leiterbahnen 16 ausübt. Die weiteren Leiterbahnen 16 sind somit den gleichen Einflussfaktoren ausgesetzt, die die Qualität der Isolierung beeinflussen. Die Messung des Gesamtisolationswiderstands Rᵢₛₒ an der Leiterstruktur 14 erlaubt somit eine Beurteilung des Isolierzustands der gemeinsamen Isolierlackschicht 15, ohne dass die aktiven Leiter 3, 13 mit einer Spannung beaufschlagt werden müssen.

Da die aktiven Leiter 3, 13 nicht in den Messstromkreis eingebunden sind, besteht auch keine Notwendigkeit, den Betrieb der Leiteranordnung 12 zu unterbrechen, um eine Isolationswiderstandsmessung durchzuführen.

Die **Fig. 4** zeigt eine Anwendung des erfindungsgemäßen Verfahrens aus dem Bereich der Öl- und Gasversorgung, bei der die Leiteranordnung 12 als Unterwasserversorgungsleitung 28 ausgeführt ist. Die Unterwasserversorgungsleitung 28 umschließt hier vier aktive Leiter 3 sowie vier nicht Betriebsstrom-führende, unbenutzte Leiter 26 als Leiterstruktur 14. An dieser aus den unbenutzten Leitern 26 bestehenden Leiterstruktur 14 ist das Isolationsüberwachungsgerät 20 angekoppelt. Da auch hier die Leiterstruktur 14 den gleichen Umwelteinflüssen ausgesetzt ist wie die aktiven Leiter 3, kann hier näherungsweise eine Abschätzung des Isolationszustands der Leiteranordnung 12 vorgenommen werden.

Alternativ oder ergänzend zu der Ankopplung des Isolationsüberwachungsgeräts 20 an die nicht Betriebsstrom-führenden, ungenutzten Leiter 26 kann als Leiterstruktur 14 eine leitende oder halbleitende Schirmschicht 36 der als Unterwasserversorgungsleitung 28 ausgeführten Leiteranordnung 12 verwendet werden.

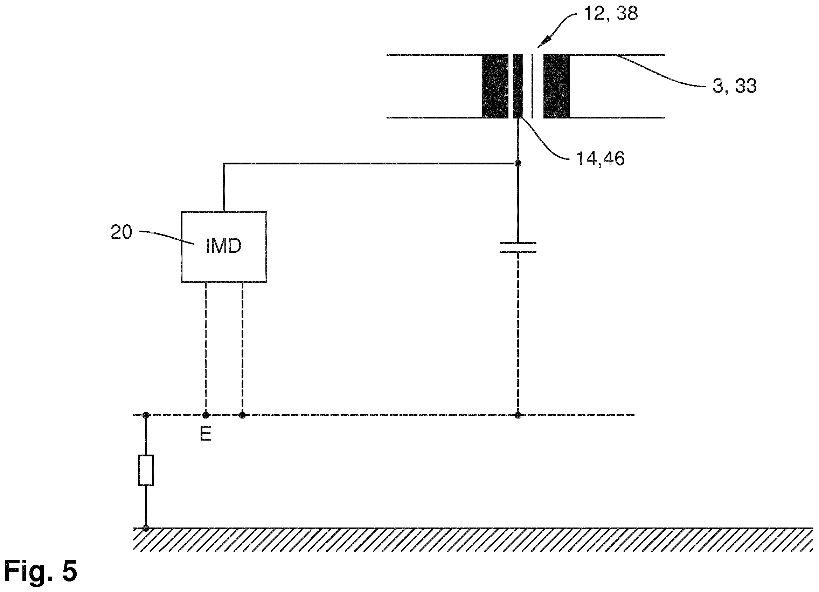

In **Fig. 5** ist eine Anwendung des erfindungsgemäßen Verfahrens in Verbindung mit einer Leiteranordnung 12 dargestellt, die als Transformator 38 ausgeführt ist.

Der Transformator 38 umfasst neben den aktiven Transformatorwicklungen 33 eine als Schirmwicklung 46 ausgebildete Leiterstruktur 14. An diese Schirmwicklung 46 ist das Isolationsüberwachungsgerät 20 angekoppelt. Auch hier liefert der Messstrom, der in dem über die Schirmwicklung 46 geschlossenen Messkreis fließt, einen Hinweis über den Isolationszustand des Transformators 38.

Sollte sich beispielsweise durch eine übermäßige Feuchteentwicklung in dem Transformator 38 der Isolationszustand verschlechtern und damit der Isolationswiderstand sinken, würde dies durch ein Ansteigen des Messstroms in dem Isolationsüberwachungsgerät 20 festgestellt werden.

## Patentansprüche

1. Verfahren zur kontinuierlichen Isolationsüberwachung einer elektrischen Leiteranordnung (12) mit einem aktiven Leiter (3) und einer von dem aktiven Leiter (3) elektrisch isolierten Leiterstruktur (14), wobei die Beschaffenheit der Leiteranordnung (12) sowie die Anordnung des aktiven Leiters (3) und der Leiterstruktur (14) derart ist, dass für den aktiven Leiter (3) und die Leiterstruktur (14) nahezu identische Ausbreitungsbedingungen für einen Stromfluss gegen Erde (E) gelten und dass Einflussfaktoren, die dazu geeignet sind, den Isolationswiderstand der Leiteranordnung (12) zu beeinflussen, gleichermaßen sowohl auf den aktiven Leiter (3) als auch auf die Leiterstruktur (14) einwirken, umfassend die Verfahrensschritte:
Durchführen einer Isolationswiderstandsmessung, wobei zwischen die Leiterstruktur (14) und Erde (E) ein normgerechtes Isolationsüberwachungsgerät (20) zur kontinuierlichen Bestimmung eines Isolationswiderstandes geschaltet wird, welches der elektrischen Leiteranordnung (12) eine Messspannung überlagert, die einen dem Isolationswiderstand der Leiteranordnung (12) proportionalen Messstrom erzeugt, der in dem Isolationswiderstandsmessgerät (20) erfasst und ausgewertet wird,
wobei als Leiterstruktur (14) ein oder mehrere nicht Betriebsstrom-führende(r) Leiter (26) der Leiteranordnung (12) verwendet wird/werden.

2. Verfahren zur kontinuierlichen Isolationsüberwachung einer elektrischen Leiteranordnung (12) mit einem aktiven Leiter (3) und einer von dem aktiven Leiter (3) elektrisch isolierten Leiterstruktur (14), wobei die Beschaffenheit der Leiteranordnung (12) sowie die Anordnung des aktiven Leiters (3) und der Leiterstruktur (14) derart ist, dass für den aktiven Leiter (3) und die Leiterstruktur (14) nahezu identische Ausbreitungsbedingungen für einen Stromfluss gegen Erde (E) gelten und dass Einflussfaktoren, die dazu geeignet sind, den Isolationswiderstand der Leiteranordnung (12) zu beeinflussen, gleichermaßen sowohl auf den aktiven Leiter (3) als auch auf die Leiterstruktur (14) einwirken, umfassend die Verfahrensschritte:
Durchführen einer Isolationswiderstandsmessung, wobei zwischen die Leiterstruktur (14) und Erde (E) ein normgerechtes Isolationsüberwachungsgerät (20) zur kontinuierlichen Bestimmung eines Isolationswiderstandes geschaltet wird, welches der elektrischen Leiteranordnung (12) eine Messspannung überlagert, die einen dem Isolationswiderstand der Leiteranordnung (12) proportionalen Messstrom erzeugt, der in dem Isolationswiderstandsmessgerät (20) erfasst und ausgewertet wird,
wobei als Leiterstruktur (14) eine Schirmschicht (36) verwendet wird.

3. Verfahren zur kontinuierlichen Isolationsüberwachung einer elektrischen Leiteranordnung (12) mit einem aktiven Leiter (3) und einer von dem aktiven Leiter (3) elektrisch isolierten Leiterstruktur (14), wobei die Beschaffenheit der Leiteranordnung (12) sowie die Anordnung des aktiven Leiters (3) und der Leiterstruktur (14) derart ist, dass für den aktiven Leiter (3) und die Leiterstruktur (14) nahezu identische Ausbreitungsbedingungen für einen Stromfluss gegen Erde (E) gelten und dass Einflussfaktoren, die dazu geeignet sind, den Isolationswiderstand der Leiteranordnung (12) zu beeinflussen, gleichermaßen sowohl auf den aktiven Leiter (3) als auch auf die Leiterstruktur (14) einwirken, umfassend die Verfahrensschritte:
Durchführen einer Isolationswiderstandsmessung, wobei zwischen die Leiterstruktur (14) und Erde (E) ein normgerechtes Isolationsüberwachungsgerät (20) zur kontinuierlichen Bestimmung eines Isolationswiderstandes geschaltet wird, welches der elektrischen Leiteranordnung (12) eine Messspannung überlagert, die einen dem Isolationswiderstand der Leiteranordnung (12) proportionalen Messstrom erzeugt,
der in dem Isolationswiderstandsmessgerät (20) erfasst und ausgewertet wird,
wobei im Fall eines Transformators (38) als Leiteranordnung (12) eine kapazitiv geerdete Schirmwicklung (46) des Transformators (38) als Leiterstruktur (14) verwendet wird.

4. Anwendung des Verfahrens nach einem der Ansprüche 1 bis 3 zur kontinuierlichen Isolationsüberwachung einer elektrischen Leiteranordnung (12) eines ungeerdeten Stromversorgungssystems (2).

5. Anwendung des Verfahrens nach einem der Ansprüche 1 bis 3 zur kontinuierlichen Isolationsüberwachung einer elektrischen Leiteranordnung eines geerdeten Stromversorgungssystems.

## Claims

1. A method for the continuous insulation monitoring of an electrical conductor arrangement (12) having an active conductor (3) and a conductor structure (14) electrically insulated from the active conductor (3), wherein the quality of the conductor arrangement (12) as well as the arrangement of the active conductor (3) and the conductor structure (14) is such that almost identical propagation conditions for the active conductor (3) and the conductor structure (14) apply to a current flow against ground (E) and that influential factors which are suitable for influencing the insulation resistance of the conductor arrangement (12) act equally on both the active conductor (3) and the conductor structure (14), the method comprising the steps:
carrying out an insulation resistance measurement, wherein a standardized insulation monitoring unit (20) is connected between the conductor structure (14) and ground (E) for continuously determining an insulation resistance, the insulation monitoring unit (20) superimposing a measurement voltage onto the electrical conductor arrangement (12), which generates a measurement current proportionally to the insulation resistance of the conductor arrangement (12), which is acquired in the insulation resistance measurement unit (20) and evaluated
wherein one or a plurality of conductors (26) of the conductor arrangement (12), which do not carry operating current, is/are used as a conductor structure (14).

2. A method for the continuous insulation monitoring of an electrical conductor arrangement (12) having an active conductor (3) and a conductor structure (14) electrically insulated from the active conductor (3), wherein the quality of the conductor arrangement (12) as well as the arrangement of the active conductor (3) and the conductor structure (14) is such that almost identical propagation conditions for the active conductor (3) and the conductor structure (14) apply to a current flow against ground (E) and that influential factors which are suitable for influencing the insulation resistance of the conductor arrangement (12) act equally on both the active conductor (3) and the conductor structure (14), the method comprising the steps:
carrying out an insulation resistance measurement, wherein a standardized insulation monitoring unit (20) is connected between the conductor structure (14) and ground (E) for continuously determining an insulation resistance, the insulation monitoring unit (20) superimposing a measurement voltage onto the electrical conductor arrangement (12), which generates a measurement current proportionally to the insulation resistance of the conductor arrangement (12), which is acquired in the insulation resistance measurement unit (20) and evaluated wherein a shielding layer (36) is used as a conductor structure (14).

3. A method for the continuous insulation monitoring of an electrical conductor arrangement (12) having an active conductor (3) and a conductor structure (14) electrically insulated from the active conductor (3), wherein the quality of the conductor arrangement (12) as well as the arrangement of the active conductor (3) and the conductor structure (14) is such that almost identical propagation conditions for the active conductor (3) and the conductor structure (14) apply to a current flow against ground (E) and that influential factors which are suitable for influencing the insulation resistance of the conductor arrangement (12) act equally on both the active conductor (3) and the conductor structure (14), the method comprising the steps:
carrying out an insulation resistance measurement, wherein a standardized insulation monitoring unit (20) is connected between the conductor structure (14) and ground (E) for continuously determining an insulation resistance, the insulation monitoring unit (20) superimposing a measurement voltage onto the electrical conductor arrangement (12), which generates a measurement current proportionally to the insulation resistance of the conductor arrangement (12), which is acquired in the insulation resistance measurement unit (20) and evaluated
wherein in the case of a transformer (38) as a conductor arrangement (12), a capacitively earthed shielding winding (46) of the transformer (38) is used as a conductor structure (14).

4. An application of the method according to one of the Claims 1 to 3 for the continuous insulation monitoring of an electrical conductor arrangement (12) of an unearthed power supply system (2).

5. An application of the method according to one of the Claims 1 to 3 for the continuous insulation monitoring of an electrical conductor arrangement of an earthed power supply system.

## Revendications

1. Procédé pour la surveillance continue d'isolement d'un armement de conducteur (12) électrique ayant un conducteur actif (3) et une structure de conducteur (14) isolée électriquement du conducteur actif (3), dans lequel la qualité de l'armement de conducteur (12) et l'armement du conducteur actif (3) et de la structure de conducteur (14) sont de telle manière que des conditions de propagation presque identiques s'appliquent pour le conducteur actif (3) et la structure de conducteur (14) pour un écoulement de courant mis à la terre (E) et de telle manière que des facteurs influents qui sont appropriés à influencer la résistance d'isolement de l'armement de conducteur (12) agissent de la même façon aussi bien sur le conducteur actif (3) que sur la structure de conducteur (14), le procédé comprenant les étapes suivantes :
exécuter une mesure d'une résistance d'isolement, dans lequel un contrôleur d'isolement (20) adapté aux normes est connecté entre la structure de conducteur (14) et la terre (E) pour la détermination continue de la résistance d'isolement, dans lequel le contrôleur d'isolement (20) superpose une tension de mesure à l'armement de conducteur (12) électrique, dans lequel la tension de mesure génère un courant de mesure qui est proportionnel à la résistance d'isolement de l'armement de conducteur (12) et qui est enregistré dans le contrôleur (20) de mesure de résistance d'isolement et est évalué,
dans lequel un ou plusieurs conducteurs (26) de l'armement de conducteur (12), qui ne transportent pas de courant d'emploi, sont utilisés comme structure de conducteur (14).

2. Procédé pour la surveillance continue d'isolement d'un armement de conducteur (12) électrique ayant un conducteur actif (3) et une structure de conducteur (14) isolée électriquement du conducteur actif (3), dans lequel la qualité de l'armement de conducteur (12) et l'armement du conducteur actif (3) et de la structure de conducteur (14) sont de telle manière que des conditions de propagation presque identiques s'appliquent pour le conducteur actif (3) et la structure de conducteur (14) pour un écoulement de courant mis à la terre (E) et de telle manière que des facteurs influents qui sont appropriés à influencer la résistance d'isolement de l'armement de conducteur (12) agissent de la même façon aussi bien sur le conducteur actif (3) que sur la structure de conducteur (14), le procédé comprenant les étapes suivantes :
exécuter une mesure d'une résistance d'isolement, dans lequel un contrôleur d'isolement (20) adapté aux normes est connecté entre la structure de conducteur (14) et la terre (E) pour la détermination continue de la résistance d'isolement, dans lequel le contrôleur d'isolement (20) superpose une tension de mesure à l'armement de conducteur (12) électrique, dans lequel la tension de mesure génère un courant de mesure qui est proportionnel à la résistance d'isolement de l'armement de conducteur (12) et qui est enregistré dans le contrôleur (20) de mesure de résistance d'isolement et est évalué,
dans lequel une couche d'écran (36) est utilisée comme structure de conducteur (14).

3. Procédé pour la surveillance continue d'isolement d'un armement de conducteur (12) électrique ayant un conducteur actif (3) et une structure de conducteur (14) isolée électriquement du conducteur actif (3), dans lequel la qualité de l'armement de conducteur (12) et l'armement du conducteur actif (3) et de la structure de conducteur (14) sont de telle manière que des conditions de propagation presque identiques s'appliquent pour le conducteur actif (3) et la structure de conducteur (14) pour un écoulement de courant mis à la terre (E) et de telle manière que des facteurs influents qui sont appropriés à influencer la résistance d'isolement de l'armement de conducteur (12) agissent de la même façon aussi bien sur le conducteur actif (3) que sur la structure de conducteur (14), le procédé comprenant les étapes suivantes :
exécuter une mesure d'une résistance d'isolement, dans lequel un contrôleur d'isolement (20) adapté aux normes est connecté entre la structure de conducteur (14) et la terre (E) pour la détermination continue de la résistance d'isolement, dans lequel le contrôleur d'isolement (20) superpose une tension de mesure à l'armement de conducteur (12) électrique, dans lequel la tension de mesure génère un courant de mesure qui est proportionnel à la résistance d'isolement de l'armement de conducteur (12) et qui est enregistré dans le contrôleur (20) de mesure de résistance d'isolement et est évalué,
dans lequel dans le cas d'un transformateur (38) comme armement de conducteur (12), un enroulement d'écran (46) mis à la terre de manière capacitive du transformateur (38) est utilisé comme structure de conducteur (14).

4. Application du procédé selon l'une quelconque des revendications 1 à 3 pour la surveillance continue d'isolement d'un armement de conducteur (12) électrique d'un système d'alimentation (2) sans mise à la terre.

5. Application du procédé selon l'une quelconque des revendications 1 à 3 pour la surveillance continue d'isolement d'un armement de conducteur électrique d'un système d'alimentation mis à la terre.
